Europäisches Patentamt

European Patent Office

Office européen des brevets

(11) Veröffentlichungsnummer: **0 453 657 A2**

# (12) EUROPÄISCHE PATENTANMELDUNG

(21) Anmeldenummer: 90125558.8

(22) Anmeldetag: 27.12.90

(51) Int. Cl.⁵: **H05K 7/20**

(30) Priorität: 27.04.90 DE 4013645

(43) Veröffentlichungstag der Anmeldung:
30.10.91 Patentblatt 91/44

(84) Benannte Vertragsstaaten:
CH DE FR GB IT LI

(71) Anmelder: **BICC-VERO ELECTRONICS GMBH**
**Carsten-Dressler-Strasse 10**
**W-2800 Bremen 61(DE)**

(72) Erfinder: **Borschewski, Dietmar**
**Woltmershauserstrasse 287**
**W-2800 Bremen 1(DE)**

(74) Vertreter: **Bohnenberger, Johannes, Dr. et al**
**Meissner, Bolte & Partner**
**Widenmayerstrasse 48 Postfach 86 06 24**
**W-8000 München 86(DE)**

(54) **Luftfilter für ein Elektronik-Gehäuse.**

(57) Bei Luftfiltern für Elektronik-Gehäuse, Baugruppenträger doer dergleichen ist das Auswechseln von Filtermatten kompliziert und erfordert meist eine Betriebsunterbrechung. Es wird ein Filter vorgeschlagen, daß einen Träger umfaßt, der die Filtermatte in einem Halterahmen hält und einen Griff aufweist, so daß er selbständig handhabbar ist. Es sind Halteeinrichtungen zum einrastbaren Halten des Trägers im Gehäuse, und zwar in dichtem Abschluß vor Lüftungsöffnungen, vorgesehen. Der Träger ist in Führungseinrichtungen führbar, die derart im Gehäsue angebracht sind, daß der Träger durch eine Einschuböffnung im Gehäuse über die Führungseinrichtung zu den Halteeinrichtungen und wieder hinaus bewegbar ist. Beim gänzlichen Einschieben des Trägers ins Gehäuse führen die Führungseinrichtungen den Träger zu Halteeinrichtungen, und zwar so, daß der Träger dicht vor den Lüftungsöffnungen aufliegt.

Die Erfindung betrifft ein Luftfilter für ein Elektronik-Gehäuse nach dem Oberbegriff des Patentanspruches 1.

Elektronische Geräte werden bekanntlich häufig in der Industrie auch an Orten verwendet, an denen die Luft staubig ist. Wenn derartige Geräte viel Wärme erzeugen, so muß diese über eine Zwangsbelüftung abgeführt werden. Um nun das Geräteinnere bzw. die Bauteile vor Staub zu schützen, ist es notwendig, die vom Lüfter aus der Umgebung angesaugte Luft zu filtern. Dann, wenn der Staubgehalt der Luft sehr hoch ist, was z. B. im einem Holz-verarbeitenden Betrieb ebenso wie in einer Gießerei der Fall ist, muß das Filter in regelmäßigen, relativ kurzen Abständen gereinigt werden. Hierfür muß bei den bekannten Geräten das Gehäuse geöffnet werden, um an das Filter zu gelangen. Dies ist zum einen zeitraubend, zum anderen erfordert es im allgemeinen ein Abschalten des Gerätes, bedingt also eine Betriebsunterbrechung.

Der Erfindung liegt die Aufgabe zugrunde, ein Luftfilter der eingangs genannten Art aufzuzeigen, bei welchem ein Filterwechsel leicht und ohne Betriebsunterbrechung des Gerätes möglich ist.

Diese Aufgabe wird durch ein Filter nach dem Patentanspruch 1 gelöst.

Ein wesentlicher Gedanke der Erfindung liegt darin, daß das Filter einen Träger zum Halten der Filtermatte umfaßt, der - wie eine Cassette - gesondert handhabbar und in eine im Gehäuse vorgesehene Öffnung so einsetzbar ist, daß die durch die Lüftungsöffnung des Gehäuses angesaugte Luft ausschließlich durch das Filter ins Gehäuseinnere gelangt.

Im einzelnen umfaßt das erfindungsgemäße Luftfilter einen Träger, in welchem die Filtermatte angebracht ist, und einen Halterahmen sowie Handhabungseinrichtungen zum selbständigen Handhaben des Trägers. Im bzw. am Gehäuse sind Halteeinrichtungen zum Halten des Trägers so vorgesehen, daß der Träger in dichtem Abschluß vor den Lüftungsöffnungen des Gehäuses einrastet. Es sind im Gehäuse Führungseinrichtungen vorgesehen, mittels derer der Träger beim Einschieben durch eine Einschuböffnung im Gehäuse zu den Halteeinrichtungen geführt wird, bis er in diesen einrastet.

Vorzugsweise sind die Führungseinrichtungen derart ausgebildet, daß der Träger beim Hineinbewegen in das Gehäuse im wesentlichen unabhängig von der Bewegungsrichtung einführbar und den Halteeinrichtungen zuführbar ist. Die Bedienungsperson muß also den Träger nicht mit Geduld und Fingerspitzengefühl in eine enge Führung "einfädeln", es ist vielmehr möglich, den Träger mit schnellem Griff einfach durch die Gehäuseöffnung hineinzustecken. Hierfür umfassen die Führungseinrichtungen eine Fangeinrichtung, an welche die führende Kante des Trägers beim Hineinschieben anstößt und an ihr entlang gleitet. Diese Fangeinrichtung kann als längliches Teil (Schiene oder Blech) ausgebildet sein, welches in ein erstes Teil der Halteeinrichtungen im wesentlichen stetig übergeht. Die Fangeinrichtung ist also geneigt zu der Richtung angebracht, in welcher das Filter auf den, die Luftansaugöffnungen umgebenden Gehäuseteil gedrückt wird, so daß eine hinreichende Andrück- und Haltekraft beim Einschieben des Trägers entsteht.

Auf der den Fangeinrichtungen gegenüberliegenden Seite, also bei der Einschuböffnung, sind weitere Halteeinrichtungen vorgesehen, welche einen Dichtrahmen umfassen, in welchem der Träger mit seinem Griffrand zum Gehäuse dicht abgeschlossen festsetzbar ist. Dieser (vorzugsweise umlaufende) Dichtrahmen ist selbstverständlich nur dann wichtig, wenn die Gefahr besteht, daß durch die Einsetzöffnung ungefilterte Luft ins Innere des Gehäuses gelangen kann.

Eine besonders bevorzugte Ausführungsform der Erfindung bezieht sich auf ein Luftfilter der eingangs genannten Art, das in Kombination mit einem Gehäuse Verwendung findet, in welchem ein Computer oder eine andere Steuerungs-/Regelungseinrichtung vorgesehen, ist, die ein Diskettenlaufwerk umfaßt, welches versenkt zur Frontplatte eingebaut ist. Ein solches Gehäuse ist aus der DE 37 11 227 C1 bekannt. Vor dem eigentlichen Diskettenlaufwerk entsteht durch die versenkte Einbauweise eine Einsenkung, die über eine, zur restlichen Gehäuse-Frontplatte parallel verlaufende und mit ihr bündig abschließende Klappe nach außen abgeschlossen ist. Bei einem derartigen Gehäsue wird nun vorgeschlagen, die Einschuböffnung zm Einschieben des Trägers in einer Seitenwand der Einsenkung anzubringen. Um das Filter zu wechseln, muß man lediglich die Klappe öffnen und kann dann den Träger herausziehen bzw. einen Träger mit gereinigter Filtermatte einschieben. Das Einschieben, welches aufgrund der notwendigerweise beengten Platzverhältnisse sonst sehr schwierig wäre, gelingt sehr leicht durch die erfindungsgemäße Anordnung und Ausbildung der Führungseinrichtung.

Weitere wesentliche Merkmale ergeben sich aus den Unteransprüchen sowie der nachfolgenden Beschreibung bevorzugter Ausführungssformen der Erfindung. Diese werden anhand von Abbildungen näher erläutert. Hierbei zeigen

Fig. 1     eine Draufsicht auf einen Träger mit Filtermatte,

Fig. 2     einen Schnitt entlang der Linie II-II aus Fig. 1,

Fig. 3     einen Teil-Horizontal- (oder Vertikal-) Schnitt durch eine Gehäuseseite mit eingesetztem Filter,

Fig. 4 einen Schnitt durch eine weitere Ausführungsform der Erfindung mit senkrecht zur Frontplatte eingesetztem Filter,

Fig. 5 einen Vertikalschnitt durch ein Gehäuse mit darin angebrachtem Diskettenlaufwerk, und

Fig. 6 einen Teil-Schnitt entlang der Linie VI-VI aus Fig. 5.

Bei der nachfolgenden Beschreibung werden für gleiche oder gleichwirkende Teile dieselben Bezugsziffern verwendet.

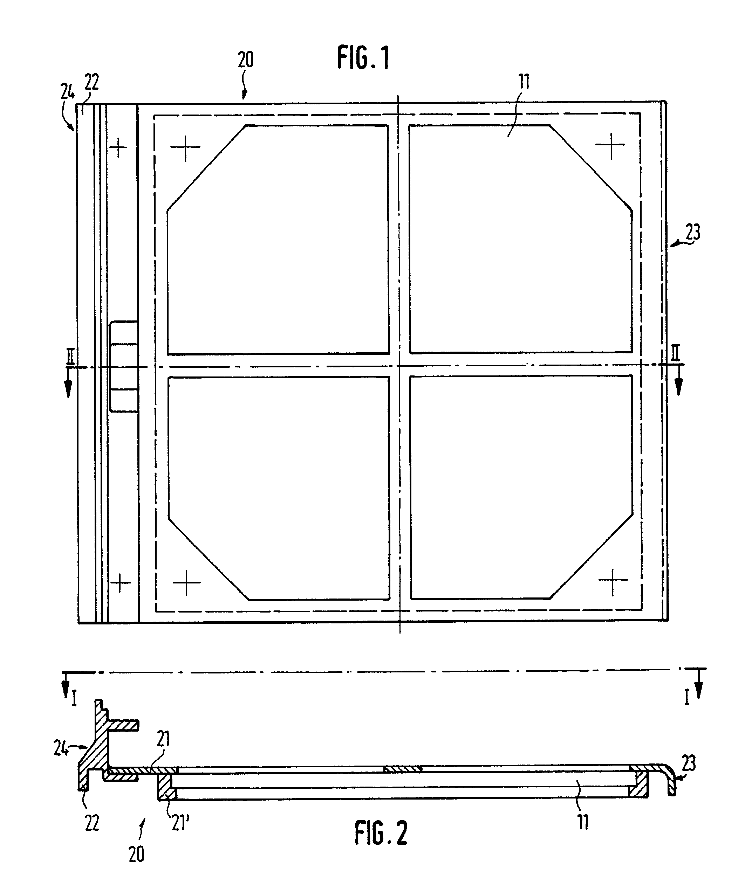

Wie in den Fig. 1 und 2 gezeigt, umfaßt das Filter 10 einen Träger 20, in welchem die Filtermatte 11 sitzt. Der Träger 20 umfaßt einen ersten Halterahmenteil 21 und einen mit diesem lösbar verbundenen zweiten Halterahmenteil 21'. Zwischen den beiden Halterahmenteilen 21, 21' wird die Filtermatte dicht mit den Rahmenteilen abschließend gehalten. Die beiden Halterahmenteile 21, 21' können z.B. mittels Rändelschrauben miteinander verbunden sein. Vorzugsweise erfolgt die Verbindung der Halterahmenteile jedoch über Federspangen, wie sie beispielsweise bei Bilderrahmen bekannt sind.

Der Träger 20 umfaßt weiterhin eine Griffkante 24, von welcher ein Griff 22 hervorsteht, an welchem der Träger 20 ergreifbar ist.

Der Griffkante 24 liegt ein führendes Teil 23 gegenüber, welches mindestens teilweise abgerundet ist.

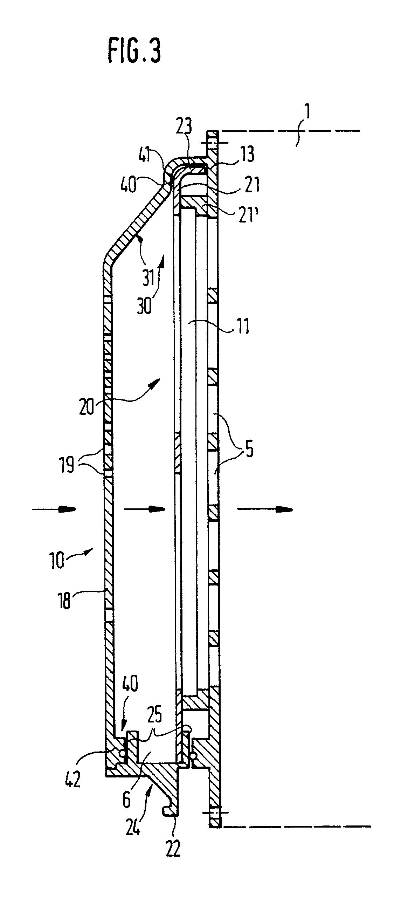

In Fig. 3 ist eine erste Alternativlösung des Filters 10 aufgezeigt. Hierbei ist vor einer Frontplatte 13 eines Gehäuses 1 ein kastenförmiges Gebilde angebracht, das seitlich, also senkrecht zur Frontplatte 13 eine offene Seite zur Bildung einer Einschuböffnung 6 aufweist. Parallel zur Frontplatte 13, in welcher Lüftungsöffnungen 5 angebracht sind, ist eine Frontfläche 18 vorgesehen, die im Bereich der Einschuböffnung 6 in einem, die Einschuböffnung 6 umgebenden Dicht- und Halterahmen 42 endet. In der Frontfläche 18 sind Lüftungsöffnungen 19 vorgesehen.

Dem Dicht- und Halterahmen 42 gegenüberliegend geht die Frontfläche 18 in eine zu ihr stumpfwinklig verlaufende Fläche über, welche wiederum abgerundet in eine zur Frontplatte des Gehäuses 1 parallele Abschnittsfläche übergeht, die wiederum rechtwinklig abgebogen auf die Frontplatte 13 zuläuft und mit ihr verbunden bzw. an ihr befestigt ist. Der Abstand zwischen der Außenfläche der Frontplatte 13 und dem zu ihr parallelen Abschnitt der Frontfläche 18 entspricht im wesentlichen dem Abstand zwischen den Außenflächen der Halterahmenteile 21, 21'.

Wenn, die in Fig. 3 gezeigt, der Träger 20 in das kastenförmige Teil vor der Frontplatte 13 eingesetzt ist, so wird durch diese Dimensionierung das Rahmenteil 21' mit seiner Außenfläche auf die Frontplatte 13 gedrückt, da die Außenfläche des Rahmenteils 21 auf dem ein erstes Teil 41 eine Halteeinrichtung 40 bildenden Abschnitt der Frontfläche 18 aufliegt. Die Griffkante 24 steckt mit Umfangsflächen 25 im Rahmen 24, der somit ein weiteres Teil der Halteeinrichtung 40 bildet. Auch hier ist die Definierung wiederum derart gewählt, daß die Außenfläche des Rahmenteils 21 im wesentlichen dicht abschließend auf der Außenfläche der Frontplatte 13 aufliegt.

Zum Wechseln der Filtermatte 11 kann man nun sehr einfach den Träger 20 am Griff 22 anfassen und herausziehen. Beim Einsetzen des Trägers 20 muß dieser lediglich ungefähr parallel zur Frontplatte 13 eingeschoben werden, da er im Verlauf des Einschiebens mit seiner höheren Kante 23 in Eingriff mit der Innenfläche des abgeschrägten Abschnitts der Frontfläche 18 gelangt, die scmit die Fangeinrichtung 31 der Führungseinrichtung 30 bildet. Sobald dies der Fall ist, wird der Träger 20 im weiteren Verlauf des Einschiebens in Richtung auf die Frontplatte 13 bedrückt, bis er in das erste Teil 41 der Halteeinrichtung 40 einrastet und die Griffkante 24 bzw. deren Umfangsflächen 25 im Halte- und Dichtrahmen 42 sitzen.

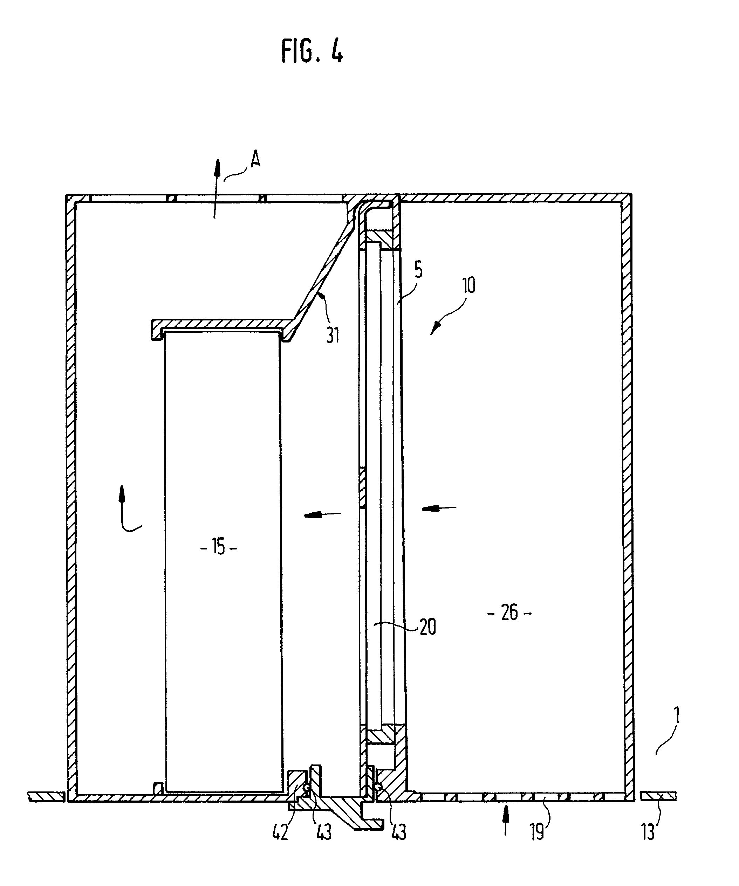

Bei der weiteren, in Fig 4 gezeigten Ausführungsform ist der Träger 20 im wesentlichen senkrecht zur Frontplatte 13 einschiebbar. Auf der einen Seite des Trägers 20 ist ein Ansaugkasten 26 vorgesehen, der über Öffnungen 19 mit der Umgebungsluft kommuniziert. Auf der anderen Seite des Trägers 30 ist ein Lüfter 15 vorgesehen,, der Luft durch das Filter 10 ansaugt und ins Innere des Gehäuses in Richtung des Pfeiles A bläst.

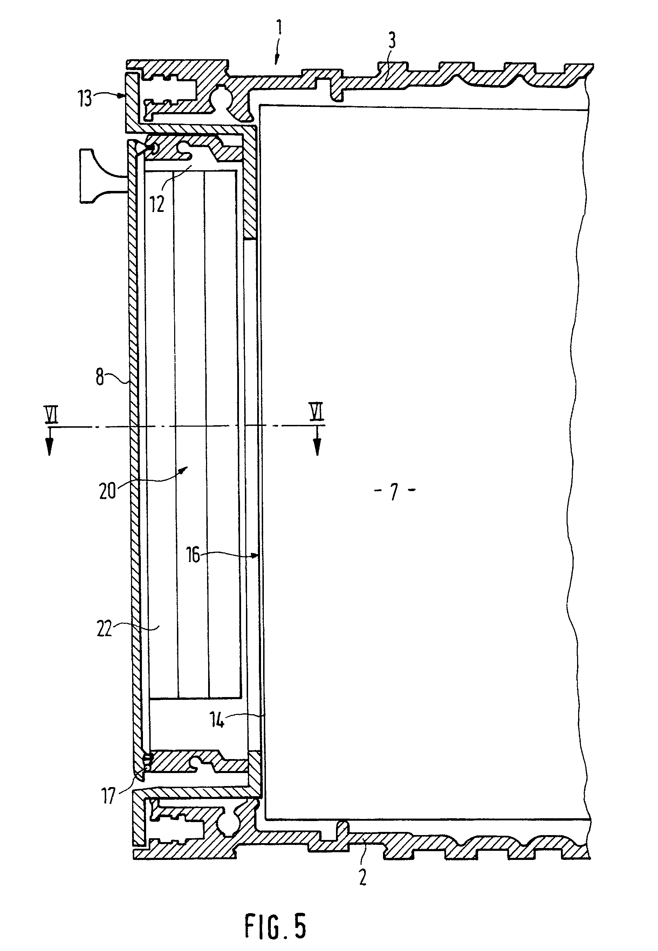

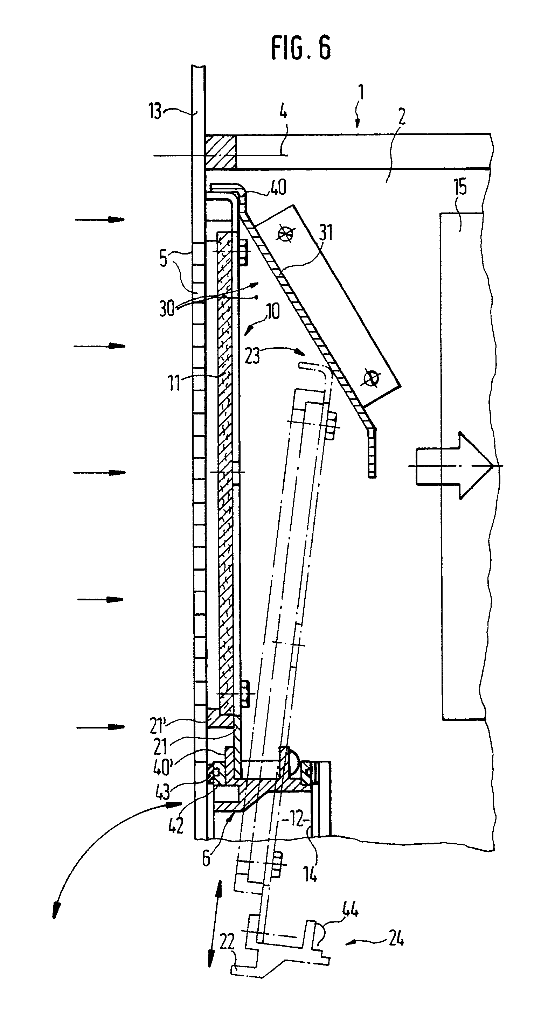

Im folgenden wird anhand der Fig. 5 und 6 eine besonders bevorzugte Ausführungsform beschrieben, die im Zusammenhang mit einem Gehäuse Verwendung findet, welches aus der DE 31 11 227 C1 bekannt ist. Hierbei ist in einem Gehäuse 1 ein Diskettenlaufwerk 7 angeordnet, welches aufgrund seiner erhöhten Bauform zurückgesetzt zur Frontplatte 13 so montiert ist, daß zwischen der Ebene der Frontplatte 13 und der Bedienungsvorderseite 14 des Diskettenlaufwerks 7 eine Einsenkung 12 entsteht. Diese Einsenkung 12 wird außenseitig durch eine Klappe 8 abgeschlossen, die mittels eines Scharniers 17 schwenkbar befestigt ist. Im geschlossenen Zustand der Klappe 8 schließt deren Außenfläche bündig mit der Frontplatte 13.

Um eine Diskette in eine Öffnung 16 des Laufwerks 7 einzuführen, wird die Klappe 8 geöffnet. Ansonsten bleibt sie geschlossen, so daß das Diskettenlaufwerk 7 vor Staub geschützt ist.

In einer Seitenwand der Einsenkung 12 ist die Einschuböffnung 6 für den Träger 20 vorgesehen.

Zum Handhaben des Trägers 20, also zum Auswechseln der Filtermatte 11 öffnet man die Klappe 8 und zieht den Träger 20 am Griff 22 heraus. Nach Auswechseln bzw. Säubern der Filtermatte 11 kann dann der Träger 20 wieder durch die Öffnung 6 eingeführt werden, wobei die Einschubrichtung aufgrund der hier wesentlichen Anbringung der Fangeinrichtungen 31 unkritisch ist. In jedem Fall wird nämlich der Träger 20 durch die Fangeinrichtungen 31 in die richtige Position geführt. Die als Blech ausgeführten Fangeinrichtungen 31 sind hierbei als Winkelblech ausgebildet und am Boden 2 des Gehäuses 1 mit Schrauben oder dgl. befestigt.

Ein sicherer Sitz und Halt des Rahmens 20 wird durch eine Rastfeder 44 (siehe auch Fig. 1) bewerkstelligt, welche bei ganz eingeschobenem Träger 20 hinter der Innenkante des Dichtrahmens 42 zu liegen kommt. Der Dichtrahmen 42 ist mit einer Dichtlippe 43 (Schnurr-Ring) versehen, um sicherzustellen, daß alle, vom Lüfter 15 angesaugte Luft durch die Lüftungsöffnungen 5 und damit durch die Filtermatte 11 strömt und nicht etwa Nebenluft angesaugt wird.

**Bezugszeichenliste**

| 1 | Gehäuse |
|---|---|
| 2 | Boden |
| 3 | Deckel |
| 4 | Seitenwand |
| 5 | Lüftungsöffnung |
| 6 | Einschuböffnung |
| 7 | Diskettenlaufwerk |
| 8 | Klappe |
| 9 | Seitenwand |
| 10 | Filter |
| 11 | Filtermatte |
| 12 | Einsenkung |
| 13 | Frontplatte |
| 14 | Bedienungsvorderseite |
| 15 | Lüfter |
| 16 | Öffnung |
| 17 | Scharnier |
| 18 | Frontfläche |
| 19 | Lüftungsöffnung |
| 20 | Träger |
| 21, 21' | Halterahmen |
| 22 | Handhabungseinrichtung |
| 23 | führendes Teil |
| 24 | Griffkante |
| 25 | Umfangsfläche |
| 26 | Ansaugkasten |
| 30 | Führungseinrichtung |
| 31 | Fangeinrichtung |
| 40 | Halteeinrichtung |
| 41 | Halteeinrichtungsteil |
| 42 | Dichtrahmen |
| 43 | Dichtlippe |
| 44 | Rastfeder |

**Patentansprüche**

1. Luftfilter für ein Elektronik-Gehäuse, einen Baugruppenträger oder dergleichen, das eine Filtermatte (11) oder dergleichen aufweist, mittels derer Staub, Feuchtigkeit und andere Verunreinigungen aus einem von außerhalb angesaugten Luftstrom entfernbar ist, **gekennzeichnet** durch einen Träger (20), in welchem die Filtermatte (11) angebracht ist und der einen Halterahmen (21, 21') sowie Handhabungseinrichtungen (Griff 22) zum selbständigen Handhaben des Trägers (20) umfaßt, Halteeinrichtungen (40) zum einrastenden Halten des Trägers (20) in/an dem Gehäuse (1) in dichtem Abschluß vor Lüftungsöffnungen (5) des Gehäuses (1), und Führungseinrichtungen (30), die derart im Gehäuse (1) angebracht sind, daß der Träger (20) durch eine Einschuböffnung (6) im Gehäuse (1) entlang der Führungseinrichtungen (30) zu den Halteeinrichtungen (40) und wieder hinaus bewegbar und in die Halteeinrichtungen (40) einrastbar ist.

2. Luftfilter nach Anspruch 1, dadurch gekennezichnet, daß die Führungseinrichtungen (30) derart ausgebildet sind, daß der Träger (20) beim Hineinbewegen in das Gehäuse (1) im wesentlichen unabhängig von der Bewegungsrichtung einbringbar und den Halteeinrichtungen (40) zuführbar ist.

3. Luftfilter nach Anspruch 2, dadurch gekennzeichnet, daß die Führungseinrichtungen (30) eine Fangeinrichtung (31) umfassen, die mit einem in Einführ-Bewegungsrichtung führenden Teil (23) des Trägers in Gleiteingriff bringbar sind und dabei den Träger (20) in dichten Abschluß vor die Lüftungsöffnungen zwingt.

4. Luftfilter nach Anspruch 3, dadurch gekennzeichnet, daß die Fangeinrichtung (31) als längliches Teil oder Blech ausgebildet ist, welches in ein erstes Teil (41) der Halteeinrichtung (40, 40') im wesentlichen stetig übergeht.

5. Luftfilter nach einem der vorhergehenden Ansprüche, dadurch gekennzeichnet, daß die Halteeinrichtungen (40) einen Dichtrahmen (42) umfassen, in welchem der Träger (20) mit einem Griffrand (24) zum Gehäuse (1) dicht abgeschlossen festsetzbar ist.

6. Verwendung eines Luftfilters in einem Elektronik-Gehäuse, in welchem ein austauschbarer Massenspeicher (Diskettenlaufwerk) einbaubar ist, dadurch gekennzeichnet, daß die Einschuböffnung (6) in einer Seitenwand (9) einer Einsenkung (12) angebracht ist, die durch eine (Bedienungs-)Vorderseite (14) des Massenspeichers (7) in ihrer Tiefe abgeschlossen ist.

EP 0 453 657 A2

FIG.1

FIG.2

# FIG.3

# FIG. 4

FIG. 5

# FIG. 6